Europäisches Patentamt

(19) European Patent Office

Office européen des brevets

(11) Numéro de publication: **0 233 103**
**B1**

(12) **FASCICULE DE BREVET EUROPEEN**

(45) Date de publication du fascicule du brevet: **05.09.90**

(51) Int. Cl.⁵: **H 01 L 23/42**

(21) Numéro de dépôt: **87400093.8**

(22) Date de dépôt: **16.01.87**

(54) Dispositifs de refroidissement de semi-conducteurs.

(30) Priorité: **16.01.86 FR 8600544**

(43) Date de publication de la demande:
**19.08.87 Bulletin 87/34**

(45) Mention de la délivrance du brevet:
**05.09.90 Bulletin 90/36**

(84) Etats contractants désignés:
**AT BE CH DE ES FR GB IT LI NL SE**

(56) Documents cités:
**DE-A-3 302 840**

**IBM TECHNICAL DISCLOSURE BULLETIN, vol.
20, no. 5, octobre 1977, pages 1769-1771, New
York, US; B.T. CLARK et al.: "Cooling device for
multilayer ceramic modules"**

(73) Titulaire: **JEUMONT-SCHNEIDER Société
anonyme dite:
31-32, Quai de Dion Bouton
F-92811 Puteaux Cedex (FR)**

(72) Inventeur: **Dumoulin, Jean Loup
5, rue Frédéric Mistral
F-77430 Champagne-sur-Seine (FR)**

(74) Mandataire: **Phélip, Bruno et al
c/o Cabinet Harlé & Phélip 21, rue de La
Rochefoucauld
F-75009 Paris (FR)**

Courier Press, Leamington Spa, England.

## Description

La présente invention concerne les dispositifs de refroidissement pour semi-conducteurs de grandes puissances, notamment thyristors, diodes et transistors.

Des dispositifs de refroidissement pour modules ceramiques multicouches sout connus, par exemple, du IBM-Technical Disclosure Bulletin, Vol. 20, No. 5, Octobre 1977, pages 1769—1771, New York, US.

Les semi-conducteurs de puissance, montés dans les équipements redresseurs employés notamment en métallurgie, électro-chimie ou embarqués à bord des navires, dégagent une quantité de chaleur importante. Elle doit être extraite des composants pour éviter que ceux-ci ne soient détruits par une temperature, excessive, et ensuite évacuée à l'extérieur de la salle contenant les équipements pour maintenir dans celle-ci une température ambiante acceptable.

Une solution consiste à placer, directement sur au moins une face du boitier du semi-conducteur, un radiateur métallique, par exemple, en cuivre ou en aluminium et à refroidissement par air ou par eau.

Une autre solution consiste à immerger les équipements comprenant des semi-conducteurs de puissance dans une enceinte fermée contenant un fluide du type composé organique. L'échange de chaleur entre les semi-conducteurs et les parois de l'enceinte se fait par changement de phase du fluide, la surface extérieure de l'enceinte étant refroidie par circulation d'air ou d'eau.

Ces solutions présentent plusieurs inconvénients:

Dans les systèmes utilisant des radiateurs à refroidissement par air, de grandes surfaces d'échange entre les radiateurs et l'air ambient sont nécessaires pour obtenir une bonne résistance thermique. Ce système de refroidissement est donc très encombrant. On peut améliorer la résistance thermique en accélérant le flux d'air au moyen de ventilateurs, mais ceux-ci sont également encombrants et, de plus, bruyants.

D'autre part, l'air chaud est rejeté soit directement dans la salle où se trouve l'équipement, ce qui nécessite l'installation de dispositifs de climatisation, soit à l'extérieur de la salle par des gaines de prise et de rejet d'air, en général très volumineuses.

Il faut, de plus, assurer un débit d'air propre pour éviter les amorçages électriques entre les radiateurs qui sont à des potentiels différents, d'où emploi fréquent de filtres à air.

Dans les systèmes utilisant des radiateurs à refroidissement par eau, la chaleur peut être évacuée directement par l'eau vers l'extérieur ou vers un réfrigérant secondaire. Mais pour assurer la circulation de l'eau, les radiateurs qui sont au potentiel des semi-conducteurs, sont reliés entre eux par des tubes en matière isolante, plus ou moins longs selon la valeur de la tension électrique.

L'eau de circulation soumise aux champs électriques doit donc être très pure et le rester. La qualité de l'eau se dégradant assez rapidement, des dispositifs de surveillance et des dispositifs régénérateurs sont nécessaires pour maintenir une bonne résistivité de l'eau. Ces dispositifs sont onéreux et encombrants et le sont d'autant plus que la tension d'utilisation est élevée.

Les systèmes utilisant une enceinte remplie d'un fluide de refroidissement susceptible de changer de phase sont insensibles aux pollutions du fluide de refroidissement puisque seules les sorties de raccordement sont sous tension à l'extérieur de l'enceinte. Mais cette solution onéreuse nécessite des semi-conducteurs et des composants auxiliaires spéciaux, compatibles avec le fluide.

Le coût des rechanges, correspondant à celui d'une cuve complète, est élevé et les manipulations difficiles.

L'invention a pour but de palier à ces inconvénients. Elle propose un dispositif assurant l'extraction de la caleur des semi-conducteurs de puissance et son évacuation vers l'extérieur qui présente les avantages suivants:

—une très bonne resistance thermique, comprise entre celle des raidateurs à air et celle des radiateurs à eau,

—la possibilité d'utiliser, pour l'evacuation de la chaleur vers l'extérieur, de l'eau industrielle ne nécessitant pas une tenue diélectrique spéciale,

—un encombrement réduit.

De plus, ce dispositif ne nécessite pas de filtre ni de système régénérateur pour le fluide de refroidissement, ni de dispositif de climatisation. Enfin, ce dispositif est silencieux.

La présente invention a donc pour objet un dispositif de refroidissement pour semi-conducteur de puissance comprenant un évaporateur métallique rempli d'un fluide caloporteur et au moins un condenseur constitué par un tube dont la paroi interne comporte une structure capillaire et qui est fermé à une extrémité et prolongé à l'autre extrémité par un conduit caractérisé en ce que l'evaporateur est concu pour être mis en contact étroit avec une face dudit semi-conducteur et en ce que le conduit est en matière isolante, ledit dispositif comprenant de plus une enveloppe enfermant le tube et fixée à la partie supérieure du conduit de façon à ménager une chambre pour la circulation d'un fluide de refroidissement, le conduit étant relié à l'évaporateur par une pièce élastique, et la pression qui règne à l'intérieur de l'ensemble constitué par l'évaporatuer, le/les condenseur (s) et le conduit, étant inférieure à la pression atmosphérique.

L'invention sera mieux comprise et d'autre buts, avantages et caractéristiques de celle-ci apparaîtront plus clairement à la lecture de la description suivante faite en référence aux Figures qui représentent des exemples non limitatifs de réalisation de l'invention.

La Figure 1 représente un exemple de réalisation de l'invention, en vue générale et en coupe selon la ligne A—A.

La Figure 2 représente une première variante de l'exemple de réalisation de la Figure 1.

La Figure 3 représente une deuxième variante de l'exemple de réalisation de la Figure 1.

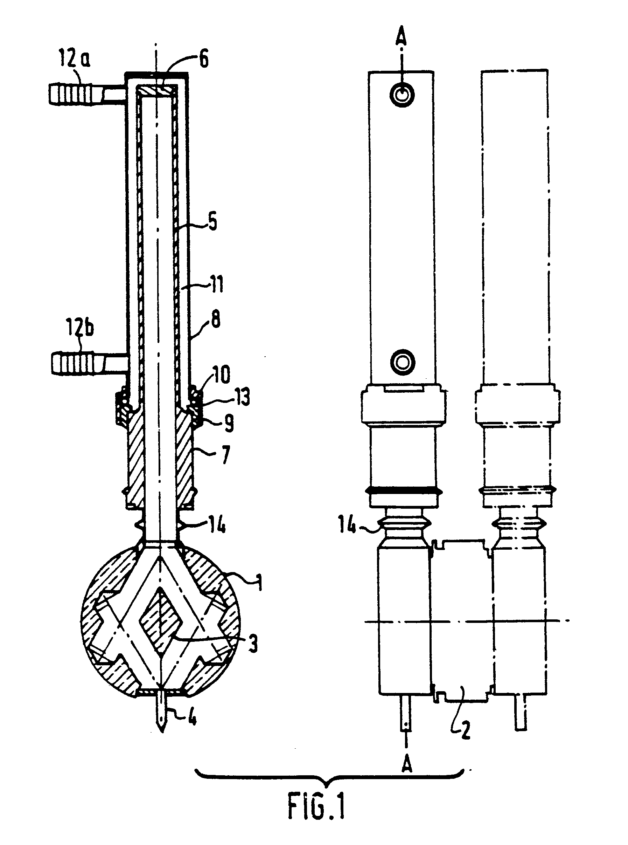

En référence à la Figure 1, le dispositif de refroidissement selon l'invention comprend essentiellement un évaporatuer métallique 1, un condenseur 5 constitué d'un tube en matière isolante, un conduit 7 également en matière isolante et réalisé par exemple en une seule pièce avec le tube 5, une pièce 14 raccordant le condenseur à l'évaporateur.

L'évaporateur 1 est adapté à la forme du boitier du semi-conducteur 2, de façon à pouvoir être placé en contact avec une face de ce boitier. Il peut être réalisé en cuivre.

Le condenseur est de préférence réalisé en céramique à base d'alumine qui est un excellent isolant électrique et un conducteur thermique relativement bon. De plus, ce type de céramique se prête bien aux opérations de raccordement étanche céramique-metal.

Le tube condenseur est hermétiquement fermé dans sa partie supérieure par un bouchon isolant 6 scellé.

Sa paroi interne comporte une structure capillaire, notamment une mêche treillée qui peut être métallique.

L'ensemble constitué par le condenseur 5 et le conduit 7 est fixé à la partie supérieure de l'évaporateur par la pièce 14, réalisée de préférence en cuivre. Elle permet d'absorber les différences de dilatation entre l'isolant et le métal.

L'évaporateur 1 est rempli d'un fluide caloporteur et sa paroi interne est conçue de façon à présenter une grande surface d'échange avec ce fluide. Il présente une section moyenne de métal capable de conduire le courant électrique maximal délivré par le semi-conducteur et, en son centre, un noyau rigide 3 qui supporte les efforts de serrage avec les semi-conducteurs.

Un tube de cuivre 4 fixé à la partie inférieure de l'évaporateur 1 permet de procéder aux opérations de nettoyage, dégazage, vidage et remplissage.

Le conduit 7 est un prolongement du tube 5, par exemple de plus grande épaisseur de façon à assurer le renforcement mécanique du tube.

Un tube de même axe que le tube 5 et de diamètre supérieur constituant l'enveloppe 8 du tube 5 est fixé sur la partie supérieure du conduit 7, par exemple par l'intermédiaire d'une pièce 10 solidaire de l'enveloppe et fixée sur une pièce 9 brasée sur le conduit, un joint 13 étant monté entre ces deux pièces.

L'enveloppe 8 peut être facilement démontée pour le nettoyage de la surface externe du condenseur.

Une chambre 11 est ainsi ménagée entre le tube 5 et son enveloppe 8. Deux embouts cannelés 12a et 12b sont fixés dans l'enveloppe 8 et permettent de relier la chambre 11 à un circuit d'eau industrielle. La paroi externe du condenseur est alors refroidie par circulation d'eau dans la chambre 11.

L'intérieur de l'ensemble fermé constitué par le condenseur et l'évaporateur étant en dépression par rapport à l'atmosphère, le fonctionnement du dispositif de refroidissement selon l'invention est le suivant:

La chaleur dégagée par le semi-conducteur 2 est transmise par contact à l'évaporateur 1.

L'évaporateur étant en dépression, le fluide caloporteur qu'il contient s'évapore facilement. La vapeur traverse le conduit 7 sans changer notablement de température et atteint le condenseur où elle se refroidit et se condense sur la paroi interne. La pression capillaire des condensats augmente.

Sous l'effet de cette pression et de la gravitation, les condensats gagnent l'évaporateur.

Il apparait donc nécessaire que le condenseur soit placé au-dessus de l'évaporateur. Cependant une inclinaison du condenseur inférieure à 70° par rapport à la verticale ne modifie pas le fonctionnement du système de refroidissement.

Le fluide caloporteur est de préférence de l'eau. Il n'est pas nécessaire qu'il ait une bonne tenue diélectrique, car même s'il est en liaison directe avec l'évaporateur sous tension, il est isolé de l'eau externe de refroidissement par la paroi isolante du condenseur.

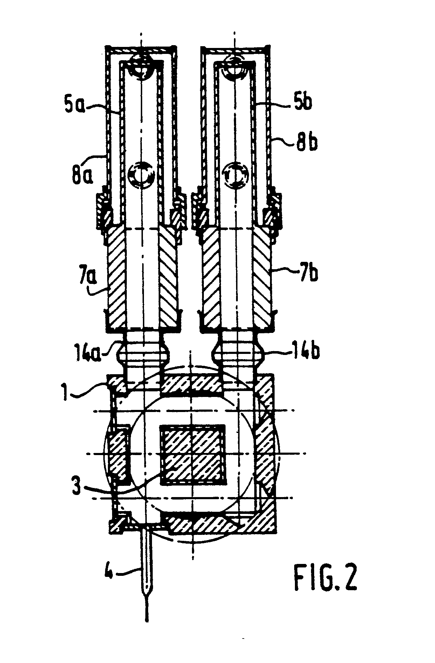

Selon la première variante de réalisation représentée à la Figure 2, l'évaporateur 1 est conçu pour être raccorde à deux tubes condenseurs 5a, 5b.

Les éléments constitutifs sont référencés de la même manière que sur la Figure 1 mais sont affectés d'un indice a ou b, selon qu'ils concernent l'un ou l'autre condenseur.

Cette disposition multiplie le nombre de pièces et de liaisons isolant-metal mais elle présente l'avantage de réduire très sensiblement la hauteur du système de refroidissement tout en conservant des surfaces d'échanges identiques à celles de la realisation de base.

Il est bien évident que plus de deux condenseurs peuvent être raccordés au même évaporateur.

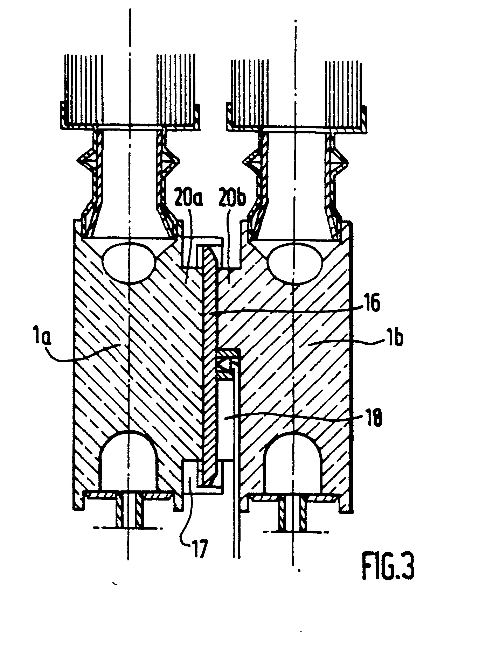

En référence maintenant à la Figure 3 qui représente une deuxième variante de réalisation de l'invention, le boitier étanche en céramique du semi-conducteur 2 est supprimé.

Deux dispositifs de refroidissement sont prévus et leurs évaporateurs 1a, 1b sont pourvus de bossages 20a, 20b qui servent d'électrodes pour le semi-conducteur et qui sont mis directement en contact avec la pastille semi-conductrice 16.

Les bossages 20a, 20b permettent aussi de monter la pièce isolante 17 de centrage et d'allongement des lignes de fuites entre les deux faces de la pastille 16. Dans le cas où le semi-conducteur 2 est un thyristor, un canal de gâchette 18 est prévu pour sortir le fil de gâchette.

L'ensemble constitué par les deux évaporateurs 1a, 1b et la pastille semi-conductrice 16 est placé dans un boitier en matière isolante ou métallique et peut alors être immergé dans un gel silicone qui a la propriété de durcir en gardant une bonne élasticité. Ce gel assure l'isolement en tension des deux faces de la pastille.

Pour une surface d'échange du condenseur identique cette deuxième variante de réalisation permet d'obtenir un gain en énergie extraite du semi-conducteur d'environ 22% par rapport à la réalisation de base.

Selon une troisième variante de réalisation le tube condenseur 5 en isolant est remplacé par un tube métallique, de préférence en cuivre, de meilleure résistance thermique.

La structure capillaire du tube condenseur peut, dans ce cas, être constituée par un rainurage fin longitudinal de la surface interne du tube conducteur.

Le tube 5 est alors relié à l'évaporateur par l'intermédiaire du conduit isolant 7 et de la pièce 14 permettant d'absorber les différences de dilatations.

Les pièces de fixation de l'enveloppe externe 8 du tube 5 sur le conduit 7 sont identiques à celles décrites dans la réalisation de base, mise à part la pièce 9 qui est, dans ce cas, brasée à la fois avec le conduit isolant 7 et le tube condenseur 5.

Pour obtenir une bonne isolation thermique entre l'évaporateur 1 et le condenseur 5, il fait que le conduit isolante 7 et le fluide caloporteur aient une bonne tenue diélectrique.

On peut utiliser une eau très poure ou un composé organique de meilleure tenue diélectrique mais moins bon caloporteur.

Pour une surface d'échange du condenseur identique et avec le même fluide, cette troisième variante de réalisation permet d'obtenir un gain en énergie extraite du semi-conducteur d'environ 19% par rapport à la réalisation de base. Cependant la tenue diélectrique est plus faible à cause du fluide interne, ce qui diminue la tension d'application.

La durée de vie est aussi liée à l'évolution de la tenue diélectrique du fluide avec le temps. Elle peut cependant être longue puisque le fluide est sous vide et en contact avec seulement deux matériaux parfaitement dégazés.

En particulier, l'évaporateur peut être prolongé par une plage de raccordement électrique, l'ensemble composé par l'évaporateur et la plage étant constitue d'une même pièce métallique ce qui entraîne une diminution du nombre de pièce et de contacts électriques.

Dans la deuxième variante de réalisation décrite ci-avant, le boitier peut inclure d'autres composants électriques que le gel silicone entoure également.

## Revendications

1. Dispositif de refroidissement pour semi-conducteur de puissance, comprenant un évaporateur métallique rempli d'un fluide caloporteur et au moins un condenseur constitué par un tube dont la paroi interne comporte une structure capillaire et qui est fermé à une extrémité et prolongé à l'autre extrémité par un conduit, caractérisé en ce que l'évaporateur (1) est conçu pour être mis en contact étroit avec une face dudit semi-conducteur (2) et en ce que le conduit (7) est en matière isolante, ledit dispositif comprenant de plus une enveloppe (8), enfermant le tube (5) et fixée à la partie supérieure du conduit (7), de façon à ménager une chambre (11) pour la circulation d'un fluide de refroidissement, le conduit (7) étant relié à l'évaporateur (1) par une pièce élastique (14), et la pression qui règne à l'intérieur de l'ensemble constitué par l'évaporateur (1), le/ les condenseur(s) (5) et le conduit (7) étant inférieure à la pression atmosphérique.

2. Dispositif selon la revendication 1, caractérisé en ce que deux embouts cannelés (12a, 12b) sont fixés dans l'enveloppe (8) et permettent de raccorder la chambre (11) à un circuit de circulation d'un fluide de refroidissement.

3. Dispositif selon les revendications 1 ou 2, caractérisé en ce que l'évaporateur comporte en son centre un noyau rigide supportant les efforts de serrage des semi-conducteurs.

4. Dispositif selon l'une quelconque des revendications précédentes, caractérisé en ce que le condenseur est réalisé dans une matière isolante, ladite structure capillaire étant constituée par une mèche treillée.

5. Dispositif selon la revendication 4, caractérisé en ce que le condenseur et le conduit constituent une seule pièce.

6. Dispositif selon les revendications 4 ou 5, caractérisé en ce que le fluide caloporteur est de l'eau.

7. Dispositif selon l'une quelconque des revendications 1 à 3, caractérisé en ce que le condenseur est métallique, la structure capillaire étant constituée par un rainurage fin longitudinal de sa paroi interne.

8. Dispositif selon la revendication 7, caractérisé en ce que le fluide caloporteur présente une bonne tenue diélectrique.

9. Dispositif selon l'une quelconque des revendications précédentes, caractérisé en ce que l'évaporateur comporte un bossage en contact direct avec la pastille semi-conductrice du semi-conducteur, ledit bossage permettant le centrage de la pastille et l'allongement des lignes de fuite.

## Patentansprüche

1. Kühlvorrichtung für einen Leistungs-Halbleiter, mit einem metallischen Verdampfer, der mit einem Wärmeträger-Fluid gefüllt ist, und mit wenigstens einem Kondensor, der aus einem Rohr besteht und dessen Innenwand eine kapillare Struktur aufweist und an einem Ende geschlossen und an seinem anderen Ende durch eine Leitung verlängert ist, dadurch gekennzeichnet, daß der Verdampfer (1) so ausgelegt ist, daß er in engen Kontakt mit einer Fläche des genannten Halbleiters (2) tritt, und daß die Leitung (7) aus einem isolierenden Material besteht, wobei die genannte Vorrichtung ferner eine Hülle (8) umfaßt, die die Leitung (5) einschließt und an dem oberen Teil der Leitung (7) befestigt ist, so daß eine Kammer (11) für die Zirkulation eines Kühl-Fluids gebildet wird, wobei die Leitung (7) durch einen elastischen Teil (14) mit dem Verdampfer (1) verbunden ist und der Druck, der innerhalb der durch den Verdampfer (1), den/die Kondensor(en) (5) und die Leitung (7) gebildeten Einheit herrscht, kleiner als der Luftdruck ist.

2. Vorrichtung nach Anspruch 1, dadurch gekennzeichnet, daß zwei geriffelte Übergangsrohrstücke (12a, 12b) in der Hülle (8) befestigt sind und es ermöglichen, die Kammer (11) an eine Leitung zur Zirkulation eines Kühl-Fluids anzuschließen.

3. Vorrichtung nach den Ansprüche 1 oder 2, dadurch gekennzeichnet, daß das Zentrum des Verdampfers einen steifen Kern umfaßt, der den Einspann-Beanspruchungen an den Halbleitern widersteht.

4. Vorrichtung nach einem der vorstehenden Ansprüche, dadurch gekennzeichnet, daß der Kondensor aus einem isolierenden Material besteht, wobei die genannte kapillare Struktur aus einem Gitter-Docht besteht.

5. Vorrichtung nach Anspruch 4, dadurch gekennzeichnet, daß der Verdampfer sowie die Leitung eine einziges Stück bilden.

6. Vorrichtung nach den Ansprüchen 4 oder 5, dadurch gekennzeichnet, daß das Wärmeträger-Fluid Wasser ist.

7. Vorrichtung nach einem der Ansprüche 1 bis 3, dadurch gekennzeichnet, daß der Kondensor metallisch ist, wobei die kapillare Struktur aus einer feilen Längsriffelung seiner Innenwand besteht.

8. Vorrichtung nach Anspruch 7, dadurch gekennzeichnet, daß das Wärmeträger-Fluid ein gutes dielektrisches Verhalten aufweist.

9. Vorrichtung nach einem der vorstehenden Ansprüche, dadurch gekennzeichnet, daß der Verdampfer einen Höcker aufweist, der mit dem Halbleiter-Plättchen des Halbleiters unmittelbar in Kontakt steht, wobei dieser Höcker des Zentrieren des Plättchen sowie die Verlängerung der Fluchtlinien ermöglicht.

## Claims

1. A power semiconductor cooling mechanism, comprising a metallic evaporator containing a heat-carrying fluid and at least one condenser constituted by a tube whose internal wall has a capillary structure, and which is closed at one end and extended at the other end by a conduit, characterized in that the evaporator (1) is configured for face-to-face contact with the said semiconductor (2) and in that the said conduit (7) is of an insulating material, said mechanism including moreover an envelope (8), enclosing the tube (5) and secured to the upper part of the conduit (7), so as to define a chamber (11) for the circulation of a cooling fluid, the conduit (7) being connected to the evaporator (1) by a flexible piece (14), with the pressure internally the assembly of the evaporator (1), the condenser(s) (5) and the conduit (7) being below atmospheric pressure.

2. Mechanism according to claim 1, characterized in that two fluted nipples (12a, 12b) are secured within the envelope (8), and enable the chamber (11) to be connected to a flowing source of cooling fluid.

3. Mechanism according to claims 1 or 2, characterized in that the evaporator has at its center a rigid core for bearing the forces of attachment to the semiconductors.

4. Mechanism according to any of the preceding claims, characterized in that the condenser is formed of an insulating material, the said capillary structure being constituted by a lattice work.

5. Mechanism according to claim 4, characterized in that the condenser and the conduit are formed as a single piece.

6. Mechanism according to claims 4 or 5, characterized in that the heat-carrying fluid is water.

7. Mechanism according to any of claims 1 to 3, characterized in that the condenser is metallic, the capillary structure being constituted by a fine longitudinal grooving of its internal wall.

8. Mechanism according to claim 7, characterized in that the heat-carrying fluid presents a good dielectric characteristic.

9. Mechanism according to any of the preceding claims, characterized in that the evaporator has a boss in face-to-face contact with the semiconductive chip of the semiconductor, the said boss enabling centering of the chip and extension of the escape lines.

FIG.1

5a

8a

7a

14a

1

3

4

5b

8b

7b

14b

FIG.2

FIG.3